# EUROPEAN PATENT APPLICATION

(11) **EP 2 325 275 A2**
(43) Date of publication of application: **25.05.2011**
(21) Application number: 10014184.5
(22) Date of filing: 02.11.2010
(51) Int. Cl.: C09J 7/02, H01L 31/048

(54) **Adhesive sheet for protecting back face of solar battery module, and solar battery module using the same**

(30) Priority: 02.11.2009 JP 2009252461
(71) Applicant: Keiwa Inc., Osaka-shi Osaka (JP)
(72) Inventor: Osamura, Keiichi, Kitasaku-gun Nagano (JP); Kobayashi, Toshiro, Kobe-shi Hyogo (JP); Kawashima, Koji, Osaka-shi Osaka (JP)
(74) Representative: Maxton Langmaack & Partner

(57) **Abstract**

An adhesive sheet for protecting the back face of a solar battery module includes a synthetic resin substrate layer, and an adhesive compound layer laminated on the back face side of the substrate layer, and the adhesive compound layer having an average thickness of 0.01 mm or greater and 1 mm or less.

## Description

### BACKGROUND OF THE INVENTION

### Field of Invention

The present invention relates to an adhesive sheet for protecting the back face of a solar battery module, and a solar battery module using the same.

### Description of the Related Art

In recent years, solar photovoltaic power generation as a clean energy source has attracted attention owing to increasing awareness-of environmental issues such as global warming, thereby leading to development of solar batteries having a variety of configurations. This solar battery is produced by packaging a plurality of solar battery cells generally wired in series or in parallel, and is constructed with a plurality of unitized solar battery modules.

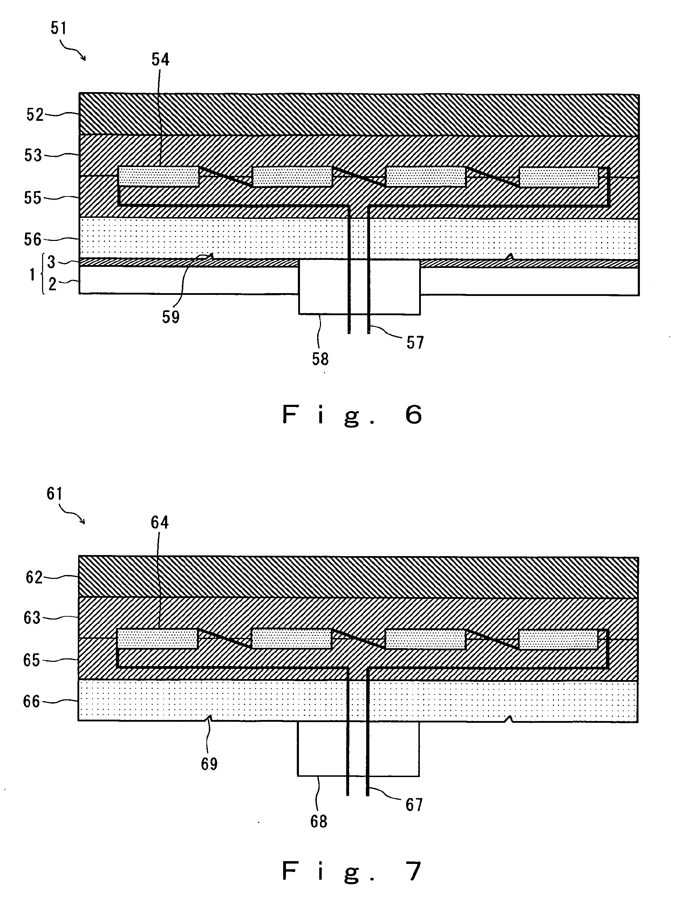

For the aforementioned solar battery modules, sufficient durability, weather resistance and the like for permitting use outdoors for a long period of time are needed. As shown in Fig. 7, in a specific structure of a general solar battery module 61, a light-transmissive substrate 62 consisting of glass or the like, a filler layer 63 consisting of a thermoplastic resin such as an ethylene-vinyl acetate copolymer (EVA) or the like, a plurality of solar battery cells 64 as a photovoltaic device, a filler layer 65 that is similar to the filler layer 63, and a back sheet 66 for the solar battery module which are laminated in this order from the front face side, and molded integrally by a vacuum heat lamination process or the like. Furthermore, solar battery cells 64 are respectively wired serially or in parallel, and two terminals 67 of this wiring are connected to a terminal of an external wiring via a junction box 68 provided on the back face (back sheet 66) side.

In the solar battery module, detachment and discoloration of the filler layers 63 and 65, corrosion of the wiring, deterioration of functions of the solar battery cell 64 may be caused when water vapor, oxygen gas or the like infiltrates inside. Therefore, according to the back sheet 66 for the solar battery module described above, gas barrier properties against, water vapor, oxygen gas and the like are needed in addition to basic performances such as strength, weather resistance, heat resistance and the like. In the conventional back sheet 66 for a solar battery module, a multilayered structure etc., has been employed in which a pair of synthetic resin layers are laminated on two faces of a gas barrier layer, for example. Specific examples of conventionally developed back sheet 66 for solar a battery module include (a) those having a structure in which a pair of polyvinyl fluoride films are laminated on both faces of an aluminum foil (see, Japanese Unexamined Patent Application Publication No. Hei 6-177412 and the like); (b) those having a structure in which a polyethylene terephthalate film is laminated on both faces of a resin film on which a metal oxide is vapor deposited (Japanese Unexamined Patent Application Publication No. 2002-100788); and the like.

However, according to the conventional back sheet 66 for a solar battery module, and the solar battery module 61 provided with the same, it is difficult to prevent damage from physical impact caused in installation and the like of solar battery panels. Such damage from physical impact, and physical defects 69 such as cracks generated by use for a long period of time, and the like deteriorate durability, insulation properties, water vapor barrier property etc., of the back sheet 66, and in turn cause deterioration of filler layers 63 and 65, thereby leading to impairment of functions of the solar battery cell 64 itself consequently. Accordingly, there exist disadvantages of failure of possible use of the solar battery module itself for a long period of time when physical defects such as cracks are caused in the back sheet 66; even though main body and the like of the solar battery cell 64 can be still used satisfactorily.

### [Prior Art Documents]

### [Patent Document]

[Patent Document 1] Japanese Unexamined Patent Application, Publication No. H6-177412
[Patent Document 2] Japanese Unexamined Patent Application, Publication No. 2002-100788

### SUMMARY OF THE INVENTION

The present invention was made taking account these disadvantages, and an object of the present invention is to provide an adhesive sheet for protecting the back face of a solar battery module and a solar battery module using the same, the adhesive sheet capable of inhibiting evolution of physical defects such as scratches and cracks generated in the back sheet by physical impact on the solar battery module or the use for a long period of time, and also preventing deterioration of a filler layer and solar battery cells which may occur due to penetration of water vapor, and the like from the physical defect sites thereof, whereby extension of useful life of the solar battery module is achieved.

An aspect of the present invention made for solving the aforementioned problems is directed to an adhesive sheet for protecting the back face of a solar battery module, the adhesive sheet including a synthetic resin substrate layer, and an adhesive compound layer laminated on one face side of the substrate layer, and the adhesive compound layer having an average thickness of 0.01 mm or greater and 1 mm or less.

According to the adhesive sheet for protecting the back face of a solar battery module, by laminating an adhesive sheet on the back face of a back sheet of the back face of the solar battery module in which physical defects such as damaging and cracks are caused, penetration of water vapor and the like from the physical defect sites can be prevented, and the expansion of the defect sites can be inhibited. In addition, according to the adhesive sheet for protecting the back face of a solar battery module, since the adhesive compound layer has an average thickness of 0.01 mm or greater and 1 mm or less, expansion of defects such as scratches and cracks can be inhibited, and penetration of water vapor and the like from outside to inside the solar battery module can be certainly prevented by embedding the adhesive compound layer into the deepest portion of the physical defect sites which can usually occur on the back sheet. In other words, according to the adhesive sheet for protecting the back face of a solar battery module, extension of useful life of the solar battery module can be achieved by providing to attach the adhesive compound layer on the back face of the back sheet.

As an adhesive compound that constitutes the adhesive compound layer, an acrylic adhesive compound is preferably used. According to the adhesive sheet for protecting the back face of a solar battery module, an acrylic adhesive compound having a strong adhesive force, and superior durability and weather resistance is used as the adhesive compound, whereby functions of inhibiting expansion of the physical defects, and preventing penetration of water vapor and the like can be certainly improved, and the functions can be sustained for a long period of time.

As the adhesive compound that constitutes the adhesive compound layer, a butyl rubber-based adhesive compound may be used. According to the adhesive sheet for protecting the back face of a solar battery module, use as the adhesive compound, of a butyl rubber-based adhesive compound having favorable weather resistance, cold resistance and following capability to irregularity enables the functions of inhibiting expansion of the physical defects and preventing penetration of water vapor and the like can be certainly improved, and the functions can be sustained for a long period of time.

As the adhesive compound that constitutes the adhesive compound layer, an ultraviolet curable adhesive compound is preferably used. According to the adhesive sheet for protecting the back face of a solar battery module, exposure to the solar light after attaching the adhesive sheet on the back face of the solar battery module leads to gradual ultraviolet curing since an ultraviolet curable adhesive compound is used as the adhesive compound. Therefore, the adhesive sheet for protecting the back face of a solar battery module can certainly fill the gaps of physical defects and prevent expansion thereof, and can enhance the strength of the adhesive sheet.

It is preferred to include a barrier layer laminated on another face side of the substrate layer and/or between the substrate layer and the adhesive compound layer, in which the barrier layer contains an inorganic substance. Since the adhesive sheet for protecting the back face of a solar battery module thus has a barrier layer containing an inorganic substance, still higher gas barrier properties against water vapor and the like are provided, and also mechanical strength can be improved.

The aforementioned inorganic substance may be an inorganic oxide or aluminum. According to the adhesive sheet for protecting the back face of a solar battery module, gas barrier properties and mechanical strength can be further improved by containing an inorganic oxide or aluminum in the barrier layer, and also prolongation of the duration of use of the solar battery module can be further promoted by suppressing elevation of the temperature of the solar battery cell owing to the heat dissipation effect. Moreover, according to the adhesive sheet for protecting the back face of a solar battery module, the rigidity is enhanced due to thus having a layer that contains a metal layer, whereby handleability of the sheet, and workability in attaching the sheet are improved.

The adhesive sheet for protecting the back face of a solar battery module preferably has another barrier layer laminated on one of face side of the above barrier layer. By the multiple barrier layers thus laminated in the adhesive sheet for protecting the back face of a solar battery module, the gas barrier properties and mechanical strength can be dramatically improved.

One face of the adhesive compound layer is preferably covered with a release sheet. Since the adhesive sheet for protecting the back face of a solar battery module can prevent the adhesive compound layer from being in contact with others due to the covering of one face with a release sheet, superior workability is maintained until just before the operation of attaching, and the adhesion function of the adhesive sheet in attaching can be improved.

Therefore, according to a solar battery module including a transparent substrate, a first filler layer, solar battery cells as a photovoltaic device, a second filler layer, a back sheet, and the adhesive sheet for protecting the back face of the solar battery module laminated in this order from the front face side, the solar battery module being characterized in that the adhesive sheet for protecting the back face of a solar battery module is provided to attach via the adhesive compound layer thereof on the back face of the back sheet, even in the case in which physical defects such as scratches and cracks generated in the back face of the back sheet, expansion of the physical defects can be inhibited, and permeabilized of water vapor and the like from the physical defect sites can be prevented by the adhesive sheet for protecting the back face of a solar battery module, whereby extension of useful life of the solar battery module can be promoted. Moreover, according to the solar battery module, suppress of occurrence per se of the physical defects of the back face of the back sheet is enabled.

The term "front face side" of the solar battery module herein means the light-receiving face side of the solar battery module. The term "back face side" means a face opposite to the front face side, i.e., the aforementioned light-receiving face side.

As described in the foregoing, according to the adhesive sheet for protecting the back face of a solar battery module of the present invention, when physical defects such as scratches and cracks occur in the back face of the back sheet of a solar battery module, the adhesive sheet provided via the adhesive compound layer leads to filling of the defect sites by the adhesive compound layer, whereby expansion of the defect sites can be suppressed, and prevention of penetration of water vapor and the like from the defect sites enables prevention of deterioration of the solar battery module, and extension of useful life can be achieved. Therefore, the solar battery module provided with the adhesive sheet for protecting the back face of a solar battery module of the present invention can inhibit deterioration of the filler layer and solar battery cells, and enables use for a long period of time.

### BRIEF DESCRIPTION OF THE DRAWINGS

Fig. 1 shows a schematic cross sectional view illustrating an adhesive sheet for protecting the back face of a solar battery module according to one embodiment of the present invention.
Fig. 2 shows a schematic cross sectional view illustrating an adhesive sheet for protecting the back face of a solar battery module according to an embodiment different from the adhesive sheet for protecting the back face of a solar battery module shown in Fig. 1.
Fig. 3 shows a schematic cross sectional view illustrating an adhesive sheet for protecting the back face of a solar battery module according to an embodiment different from the adhesive sheets for protecting the back face of a solar battery module shown in Fig. 1 and Fig. 2.
Fig. 4 shows a schematic cross sectional view illustrating an adhesive sheet for protecting the back face of a solar battery module according to an embodiment different from the adhesive sheets for protecting the back face of a solar battery module shown in Fig. 1, Fig. 2 and Fig. 3.
Fig. 5 shows a schematic cross sectional view illustrating an adhesive sheet for protecting the back face of a solar battery module according to an embodiment different from the adhesive sheets for protecting the back face of a solar battery module shown in Fig. 1 to Fig. 4.
Fig. 6 shows a schematic cross sectional view illustrating a solar battery module in which the adhesive sheet for protecting the back face of a solar battery module shown in Fig. 1 is used.
Fig. 7 shows a schematic cross sectional view illustrating a conventional and general solar battery module.

### DESCRIPTION OF THE PREFERRED EMBODIMENTS

Hereinafter, the adhesive sheet for protecting the back face of a solar battery module of the present invention, and a solar battery module using the same are explained in detail with appropriate references to the drawings.

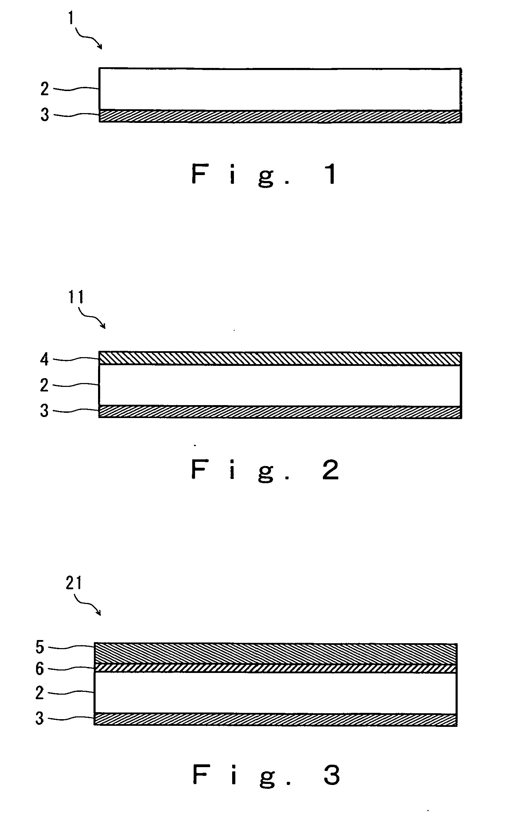

The adhesive sheet 1 for protecting the back face of a solar battery module shown in Fig. 1 has a substrate layer 2, and an adhesive compound layer 3 laminated on one face side of the substrate layer 2.

The substrate layer 2 is formed using a synthetic resin as a principal component. A synthetic resin included in the substrate layer 2 as a principal component is not particularly limited, and examples thereof include e.g., a polyolefin-derived resin, a fluorine-containing resin, a poly(meth)acrylic resin, a polycarbonate-based resin, a polyester-based resin, a polyamide-based resin, a polyimide-based resin, a polyamideimide-based resin, a polyarylphthalate-based resin, a silicone-based resin, a polysulfone-based resin, a polyphenylenesulfide-based resin, a polyether sulfone-based resin, a polyurethane-based resin, an acetal-based resin, a cellulose-based resin, an acrylonitrile-styrene copolymer (As resin), an acrylonitrile-butadiene-styrene copolymer (ABS resin), a polyvinyl chloride-based resin, and the like. Among the resins described above, polyolefin-derived resin, polyester-based resin, fluorine-containing resin having high heat resistance, physical strength, weather resistance and durability, and gas barrier properties against water vapor and the like, and the like are preferred.

Examples of the polyolefin-derived resin include polyethylene (e.g., high density polyethylene, low density polyethylene and the like), copolymers of polypropylene, ethylene with an unsaturated carboxylate ester (e.g., ethylene-vinyl acetate copolymer, ethylene-methyl acrylate copolymer, ethylene-methyl methacrylate copolymer and the like), copolymers of ethylene and unsaturated carboxylic acid (e.g., ethylene-acrylic acid copolymer, ethylene-methacrylic acid copolymer and the like), ionomer resins, and the like. Among these, polyethylene that exhibits favorable balance of costs and various functions such as resistance to hydrolysis, heat resistance, weather resistance and the like, as well as cyclic polyolefin-based resins that are excellent in functional properties such as heat resistance, strength, weather resistance, durability and gas barrier properties.

Examples of the cyclic polyolefin-based resin include e.g., a) polymers obtained by polymerization of cyclic diene such as cyclopentadiene (and a derivative thereof), dicyclopentadiene (and a derivative thereof), cyclohexadiene (and a derivative thereof), norbornadiene (and a derivative thereof) or the like, b) copolymers obtained by copolymerization of one, or two or more of the olefin-based monomers such as ethylene, propylene, 4-methyl-1-pentene, styrene, butadiene and isoprene with the cyclic diene, and the like. Among these cyclic polyolefin-based resins, polymers of cyclic diene such as cyclopentadiene (and a derivative thereof), dicyclopentadiene (and a derivative thereof) or norbornadiene (and a derivative thereof) that are excellent in the strength, heat resistance, weather resistance and the like are particularly preferred.

As the polyester-based resin, for example, polyethylene terephthalate, polyethylene naphthalate, and the like are exemplified. Among these polyester-based resins, polyethylene terephthalate having favorable balance of costs and various functions such as heat resistance, weather resistance etc., is particularly preferred.

As the fluorine-containing resin, for example, polytetrafluoroethylene (PTFE), a perfluoroalkoxy resin (PFA) constituted with a copolymer of tetrafluoroethylene with perfluoroalkylvinyl ether, a copolymer(FEP) of tetrafluoroethylene with hexafluoropropylene, a copolymer (EPE) of tetrafluoroethylene, perfluoroalkylvinyl ether and hexafluoropropylene, a copolymer (ETFE) of tetrafluoroethylene with ethylene or propylene, a polychlorotrifluoroethylene resin (PCTFE), a copolymer (ECTFE) of ethylene with chlorotrifluoroethylene, a vinylidene fluoride-based resin (PVDF), a vinyl fluoride-based resin (PVF), and the like may be exemplified. Among these fluorine-containing resins, a polyvinyl fluoride-based resin (PVF), and a copolymer (ETFE) of tetrafluoroethylene with ethylene or propylene that are superior in strength, heat resistance, weather resistance and the like are particularly preferred.

As the material for forming the substrate layer 2, the aforementioned synthetic resin can be used alone, or as a mixture of two or more thereof. Moreover, a variety of additives can be blended in the material for forming the substrate layer 2 for the purpose of improving and/or modifying the processibility, heat resistance, weather resistance, mechanical properties, dimension accuracy and the like. Examples of the additive include e.g., lubricants, crosslinking agents, antioxidants, ultraviolet ray-absorbing agents, light stabilizers, fillers, reinforcing fibers, strengthening agents, antistatic agents, fire retardants, flame retardants, foaming agents, fungicides, pigment, and the like. The method of molding the substrate layer 2 is not particularly limited, but for example, a known method such as an extrusion method, a cast molding method, a T-die method, a cutting method, an inflation method or the like may be employed. The substrate layer 2 may have either a monolayer structure, or a multilayer structure including two or more layers.

The lower limit of the average thickness of the substrate layer 2 is preferably 0.3 mm, and particularly preferably 0.5 mm. In contrast, the upper limit of the average thickness of the substrate layer 2 is preferably 5 mm, and particularly preferably 3 mm.

The substrate layer 2 having an average thickness of less than the aforementioned lower limit causes disadvantages such as bringing difficulty in handling of the adhesive sheet 1 for protecting the back face of a solar battery module, and insufficient functional properties such as barrier properties against water vapor. In particular, the adhesive sheet for protecting the back face of a solar battery module is cut to fit the size of a preexisting solar battery module and to fit the position and the size of junction box of the solar battery module, and thereafter attached to the back face of the solar battery module. Therefore, when the average thickness is less than the aforementioned lower limit, workability in cutting and attaching may be deteriorated and thus attaching to meet each solar battery module size may be difficult, or adhesiveness with a back sheet may be lowered due to attachment shifted, and may lead to failure in sufficiently exerting the function of preventing expansion of defects and the barrier function against water vapor and the like.

To the contrary, when the substrate layer 2 has a thickness exceeding the upper limit, demands for reduction in thickness and weight saving of the solar battery module may not be satisfied. Further, when the average thickness of the substrate layer 2 exceeds the above-described upper limit, the weight of the adhesive sheet 1 for protecting the back face of a solar battery module increases, whereby workability in attaching on the back face may be similarly deteriorated and thus attaching to meet each solar battery module size may be difficult, or adhesiveness with the back sheet may be lowered due to attachment shifted, and may lead to failure in sufficiently exerting the function of preventing expansion of defects and the barrier function against water vapor and the like.

The substrate layer 2 may include a pigment dispersed therein. By thus including a pigment dispersed in the substrate layer 2, various characteristics such as heat resistance, weather resistance, durability, thermal dimensional stability, strength and the like of the substrate layer 2, in turn, of the adhesive sheet 1 for protecting the back face of a solar battery module can be improved. Further, by including a white pigment dispersed in the substrate layer 2, a function of allowing the rays of light transmitted the solar battery cell to be reflected is added, whereby the power generation efficiency can be further improved. Moreover, design of the solar battery module can be improved by including a black pigment dispersed in the substrate layer 2 to provide a variously colored substrate layer 2.

The white pigment is not particularly limited, but for example, calcium carbonate, titanium oxide, zinc oxide, lead carbonate, barium sulfate or the like can be used. Among them, calcium carbonate is preferred which is excellent in dispersibility in the resin material that forms the substrate layer 2, and which exhibits a comparatively great effect of improving the durability, heat resistance, strength and the like of the substrate layer 2. The calcium carbonate can have a crystal form such as calcite, aragonite, vaterite and the like, and any crystal form is acceptable for use. This calcium carbonate may be subjected to a surface finishing treatment with stearic acid, sodium dodecylbenzenesulfonate, a silane coupling agent, a titanium coupling agent or the like, and impurities such as magnesium oxide, aluminum oxide, silicon dioxide, titanium dioxide and the like may be also included in an amount of approximately 10% or less. Examples of the other pigment include black pigments such as carbon black, blue pigments such as ultramarine and prussian blue, red pigments such as blood red (iron oxide red), cadmium red and molybdenum orange, metal powder pigments that impart metallic luster, and the like, which can be responsible for improvement of the solar battery module design.

The average particle size of the pigment is preferably 100 nm or greater and 30 µm or less, and particularly preferably 300 nm or greater and 3 µm or less. It should be noted that the average particle size referred to herein means an average of particle size of thirty particles randomly extracted from particles observed on an electron microscope at 1,000-fold magnification. In addition, the particle size is defined by means of a Feret diameter (interval determined when the profile view is sandwiched with parallel lines along a certain direction).

When the average particle size of the pigment is below the above range, uniform dispersion in the substrate layer 2 may be difficult due to the aggregation or the like. In contrast, when the average particle size of the pigment exceeds the above range, the effect of improving various characteristics such as heat resistance for the substrate layer 2 may be decreased.

The content of the pigment is preferably 8% by weight or greater and 30% by weight or less. When the content of the pigment is smaller than the aforementioned lower limit, the effect of improving the durability, heat resistance, strength and the like of the substrate layer 2 may be decreased. In contrast, when the content of the pigment is greater than the aforementioned upper limit, dispersibility of the pigment in the substrate layer 2 may be deteriorated, whereby reduction in strength of the substrate layer 2 may be caused.

Moreover, another face (face on the side to be contact with the external air) of the substrate layer 2 may be subjected to a top coating treatment. By thus subjecting another-layer of the substrate layer 2 to a top coating treatment, the substrate layer 2 can be sealed and protected. As a result, handleability of the adhesive sheet 1 is improved, and deterioration of the strength, weather resistance and the like is suppressed, even if the substrate layer 2 has defects such as scratches and recessed parts, whereby aged deterioration of the substrate layer 2 can be inhibited.

Examples of top coating agent used for the top coating treatment include e.g., polyester-based top coating agents, polyamide-based top coating agents, polyurethane-based top coating agents, epoxy-based top coating agents, phenol-based top coating agents, (meth)acrylic top coating agents, polyvinyl acetate-based top coating agents, polyolefin-based top coating agents such as polyethylene or polypropylene, cellulose-based top coating agent, and the like. Among such top coating agents, polyester-based top coating agents that exhibit high adhesion strength with the substrate layer 2, and are responsible for surface protection and the like of the substrate layer 2 are particularly preferred.

The lower limit of the amount of coating of the top coating agent (on the solid content basis) is preferably 1 g/m², and particularly preferably 3 g/m². On the other hand, the upper limit of the amount of coating of the top coating agent is preferably 10 g/m², and particularly preferably 7 g/m². When the amount of coating of the top coating agent is less than the lower limit described above, the effect of protecting the substrate layer 2 may be inferior. On the other hand, even if the amount of coating of the top coating agent exceeds the upper limit, the effect of protecting the substrate layer 2 is less likely to be enhanced, and rather leads to increase in thickness of the adhesive sheet 1, whereby results contrary to demands for reduction in thickness and weight saving may be produced.

It is to be noted that various types of additives such as a silane coupling agent for improving contact adhesion properties, an ultraviolet ray absorbing agent for improving weather resistance etc., an inorganic filler for improving heat resistance etc., may be mixed ad libitum in the top coating agent. The amount of mixing such additives is preferably 0.1% by mass or greater and 10% by mass or less in light of the balance between development of effects of the additive, and inhibition of functions of the top coating agent.

The ultraviolet ray absorbing agent which may be included in the top coating agent is not particularly limited as long as: it absorbs ultraviolet rays; can efficiently convert into a thermal energy; and is a compound stable to light, and any well-known agent may be used. In particular, salicylic acid-based ultraviolet ray absorbing agents, benzophenone-based ultraviolet ray absorbing agents, benzotriazole-based ultraviolet ray absorbing agents and cyanoacrylate-based ultraviolet ray absorbing agents that have superior function of absorbing ultraviolet rays and have favorable miscibility with the top coating agent, and present stably are preferred. One, or at least to selected from the group of these agents may be used. Moreover, a polymer having an ultraviolet ray-absorbing group in the molecular chain (for example, "UW UV" series available from Nippon Shokubai Co., Ltd., etc.) may be also used suitably as the ultraviolet ray absorbing agent. By using such a polymer having an ultraviolet ray-absorbing group in the molecular chain, high miscibility with the top coating agent is achieved, and deterioration of the function to absorb ultraviolet rays due to bleeding out of the ultraviolet ray absorbing agent can be prevented.

The adhesive compound layer 3 is formed by coating the adhesive compound on one face of the substrate layer 2. The lower limit of the average thickness of the adhesive compound layer 3 is 0.01 mm, preferably 0.015 mm, and particularly preferably 0.02 mm. In addition, the upper limit of the average thickness of the adhesive compound layer 3 is 1 mm, preferably 0.1 mm, and particularly preferably 0.05 mm. According to the adhesive sheet 1 for protecting the back face of a solar battery module including the adhesive compound layer 3 having the average thickness described above, by laminating the adhesive sheet 1 on the back sheet surface of the back face of the solar battery module on which physical defects such as scratches and cracks occurred, penetration of water vapor from the physical defect sites can be prevented, and expansion of the physical defects can be suppressed. In addition, since the average thickness of the adhesive compound layer 3 falls within the above range according to the adhesive sheet 1 for protecting the back face of a solar battery module, the adhesive compound layer 3 can be embedded into the deepest portion of physical defects which can usually occur, and expansion of the physical defects such as scratches and cracks can be inhibited, and penetration of water vapor and the like from the outside can be prevented certainly.

When the average thickness of the adhesive compound layer 3 is less than the lower limit described above, the adhesive compound cannot fill in the physical defects such as scratches and cracks having the depth that may usually occur, leading to generation of gaps. Accordingly, evolution of the expansion of the defects is accelerated, and penetration of water vapor and the like from the gap results in deterioration of barrier properties against water vapor and the like. To the contrary, when the average thickness of the adhesive compound layer 3 exceeds the upper limit described above, workability may be deteriorated such as, for example, interference of operation of cutting to make the adhesive sheet have a desired shape due to the thickness of the adhesive compound layer 3.

Although the adhesive compound which may be used in the adhesive compound layer 3 is not particularly limited, for example, acrylic adhesive compounds, acrylic rubber-based adhesive compounds, natural rubber-based adhesive compounds, synthetic rubber-based adhesive compounds such as butyl rubber-based compounds, silicone-based adhesive compounds, polyurethane-based adhesive compounds, epoxy-based adhesive compounds, polyethylene-based adhesive compounds, polyester-based adhesive compounds, and the like are exemplified. Of these, acrylic adhesive compounds because of good balance of adhesive force, retentive force and tackiness, as well as favorable durability and weather resistance, and availability at low costs, alternatively, butyl rubber-based adhesive compounds that are favorable in weather resistance, weather resistance and following capability to irregularity are particularly preferred.

Although the monomer that constitutes the acrylic adhesive compound is not particularly limited, examples thereof include: acrylic acid alkyl esters and methacrylic acid alkyl esters (wherein, alkyl group having 1 to 20 carbon atoms, for example) such as methyl acrylate, ethyl acrylate, n-butyl acrylate, methyl methacrylate, isobutyl acrylate, t-butyl acrylate, n-octyl acrylate, isooctyl acrylate, 2-ethylhexyl acrylate, isononyl acrylate, ethyl methacrylate, n-butyl acrylate, isobutyl methacrylate, and 2-ethylhexyl methacrylate; acrylic acid hydroxyalkyl esters and methacrylic acid hydroxyalkyl esters (wherein, hydroxyalkyl group having 1 to 20 carbon atoms, for example) such as 2-hydroxyethyl acrylate, 2-hydroxypropyl acrylate, 4-hydroxybutyl acrylate, 2-hydroxyethyl methacrylate, 2-hydroxypropyl methacrylate, and 4-hydroxybutyl methacrylate; unsaturated aliphatic carboxylic acids such as acrylic acid, methacrylic acid, maleic acid, fumaric acid, and itaconic acid; vinyl acetate; and combinations thereof, and the like. Of these, use of n-butyl acrylate or 2-ethylhexyl acrylate as a monomer is particularly preferred due to favorable adhesion characteristics such as adhesive force, retentive force and tackiness. The aforementioned acrylic adhesive compound is produced by allowing such a monomer to be polymerized in the presence of a polymerization initiator by solution polymerization, block polymerization, emulsion polymerization, suspension polymerization or the like with a common method. Particularly, emulsified acrylic adhesive compounds obtained by emulsion polymerization are preferred in attempts to reduce burden to the global environment and in light of safety in producing the adhesive sheet 1, since water is used as a main polymerization solvent.

The butyl rubber-based adhesive compound usually includes a butyl rubber, a softening agent and a tackifier resin.

The butyl rubber is obtained by copolymerization using isobutylene as a principal component, with isoprene in an amount of 1 to 2% by weight for permitting crosslinking. Butyl rubbers are characterized by extremely low gas permeability. The butyl rubber is preferably crosslinked for improving the balance of the adhesive force and the cohesive force, which may be carried out by vulcanization with a polyalkyl phenol resin, electron beam crosslinking, ultraviolet crosslinking carried out by adding a photoinitiator, a photopolymerizable mutilfunctional monomer (for example, trimethylolpropane triacrylate, etc.), or the like. Of these, vulcanization with a polyalkyl phenol resin is preferred because a vulcanization catalyst required for other rubber-based adhesive compounds is not necessary, and favorable heat resistance and anti-staining properties are exhibited.

The softening agent is added for the purpose of lowering the glass transition temperature of the butyl rubber to improve initial adhesion properties during a low temperature stage, whereby thereby maintaining superior balance of the cohesive force and the adhesive force. Examples of the softening agent include e.g., petroleum-based agents such as process oils and extender oils; liquid rubbers such as liquid polyisobutylene, liquid polybutene and liquid polyisoprene; dibasic acid ester-based plasticizers such as dibutylphthalate and dioctylphthalate.

The tackifier resin is added for the purpose of improving initial adhesion properties, and examples thereof include e.g., rosin-based resins such as rosins, modified rosins and rosin esters; terpene-based resins such as terpene resins, aromatic modified terpene resins, hydrogenated terpene resins and terpene phenols; petroleum resins such as aliphatic-based (C5-based) petroleum resins, aromatic (C9-based) petroleum resins, C5/C9-based copolymerized petroleum resins, alicyclic petroleum resins, coumarone indene resins and styrene-based petroleum resins; phenol-based resins such as alkylphenol resins and rosin modified phenol resins; all common tackifier resins such as xylene resins. In light of favorable weather resistance, petroleum resins are preferred.

To the butyl rubber-based adhesive compound may be added, for example, a filler, an anti-aging agent and the like ad libitum within the range to avoid deterioration of the adhesive physical properties and the like thereof.

Examples of the filler include e.g., calcium carbonate; magnesium carbonate; calcium such as dolomite; magnesium carbonate; silicic acid salts such as kaolin, calcined clay, pyrophyllite, bentonite, sericite, zeolite, nepheline syenite, talc, attapulgite and wollastonite; silicic acid such as diatomaceous earth and silica flour; aluminum hydroxide; barium sulfate such as pallite and precipitated barium sulfate; calcium sulfate such as gypsum; calcium sulfite; carbon black; zinc oxide; titanium dioxide; and the like.

Examples of the anti-aging agent include e.g., phenol-based anti-aging agents, amine-based anti-aging agents, imidazole-based anti-aging agents, dithiocarbamic acid salt-based anti-aging agents, phosphorus-based anti-aging agents, sulfur ester-based anti-aging agents, and the like.

The adhesive compound that constitutes the adhesive compound layer 3 is preferably an ultraviolet curable adhesive compound. By using an ultraviolet curable adhesive compound as the adhesive compound, the strength of the adhesive sheet 1 can be enhanced through gradual ultraviolet curing by exposure to solar light of the adhesive compound layer 3 after attaching the adhesive sheet 1 to the back face of a solar battery module.

As the ultraviolet curable adhesive compound, any one containing an ultraviolet curable component in addition to the adhesive polymer component described above may be used, or any one containing an ultraviolet curable polymer having a form in which an unsaturated double bond is added to the side chain of the adhesive polymer may be also used.

As the ultraviolet curable component, any component which causes a reaction by the ultraviolet curable component (for example, a reaction among ultraviolet curable components, a reaction between the ultraviolet curable component and other component in the adhesive compound layer (for example, an acrylic polymer, etc) or the like) upon ultraviolet irradiation may be used. Specifically, as the ultraviolet curable component, a compound such as a monomer, an oligomer or a polymer, having at least one group containing an unsaturated double bond in the molecule (unsaturated double bond-containing group) may be used, and a non volatile compound is particularly suited. The ultraviolet curable component may be used alone, or two or more thereof may be used in combination.

The unsaturated double bond-containing group in the ultraviolet curable component is particularly preferably a group containing a carbon-carbon double bond (carbon-carbon double bond-containing group), and examples of the carbon-carbon double bond-containing group, include e.g., ethylenic unsaturated bond-containing groups such as a vinyl group, allyl groups, and (meth)acryloyl groups, and the like. The unsaturated double bond-containing group may be used alone, or two or more thereof may be used in combination. One molecule of the ultraviolet curable component preferably has the unsaturated double bond-containing group in the number of at least two. When the ultraviolet curable component has at least two unsaturated double bond-containing groups in one molecule, the same unsaturated double bond-containing group may be used in multiple number, or at least two kinds of unsaturated double bond-containing groups may be used.

As the ultraviolet curable component, for example, esterified products of (meth)acrylate and a polyhydric alcohol, ester acrylic compounds, urethane acrylic compounds, cyanurate-based compounds having an unsaturated double bond-containing group, as well as isocyanurate-based compounds having an unsaturated double bond-containing group, and the like may be exemplified.

More specifically, the ultraviolet curable component may be exemplified by, for example, di(meth)acrylates of an alkylene glycol (e.g., (meth)acrylic acid di(alkylene glycol) esters; for example, di(meth)acrylates of a C1-9 alkylene glycol or a poly(C1-9 alkylene glycol) such as di(meth)acrylate of tetraethylene glycol, di(meth)acrylate of polyethylene glycol, di(meth)acrylate of propylene glycol, di(meth)acrylate of polypropylene glycol, di(meth)acrylate of 1,4-butylene glycol, di(meth)acrylate of 1,6-hexanediol, di(meth)acrylate of neopentyl glycol, etc.), 2-propenyl-di-3-butenyl cyanurate, di(meth)acrylate of tris(2-hydroxyethyl)isocyanurate, di(meth)acrylates of diols obtained by addition of 4 mol or more ethylene oxide or propylene oxide based on 1 mol of neopentyl glycol, di(meth)acrylates of bisphenol A or a modified product thereof, di(meth)acrylates of trimethylolpropane or a modified product thereof, tri(meth)acrylates of trimethylolpropane or a modified product thereof, tetramethylolmethane tetra(meth)acrylate, tris(2-hydroxyethyl)isocyanurate tri(meth)acrylate, pentaerythritol tri(meth)acrylate, pentaerythritol tetra(meth)acrylate, poly(meth)acrylates of dipentaerythritol, caprolactone-modified tris[(meth)acryloxyethyl]isocyanurate, poly(meth)acrylates of caprolactone-modified dipentaerythritol, neopentyl glycol adipate-modified di(meth)acrylate, neopentyl glycol hydroxypivalate di(meth)acrylate, hydroxypivalic acid ester-modified neopentyl glycol di(meth)acrylate, caprolactone-modified neopentyl glycol hydroxypivalate di(meth)acrylate, dioxane-modified di(meth)acrylate, cyclopentanyl di(meth)acrylate, ethylene oxide-modified phosphoric acid di(meth)acrylate, ethylene oxide-modified alkylated phosphoric acid di(meth)acrylate, poly(meth)acrylates of alkyl-modified dipentaerythritol, and the like.

Although the rate of the ultraviolet curable component contained is not particularly limited, for example, it is about 5 to 500 parts by mass, and preferably 10 to 200 parts by mass based on 100 parts by mass of the adhesive polymer component such as an acrylic resin.

It is to be noted that the ultraviolet curable adhesive compound may be blended with additives such as a photopolymerization initiator and a crosslinking agent as needed in addition to the adhesive polymer component and the ultraviolet curable component.

The photopolymerization initiator is not particularly limited as long as it is a photopolymerization initiator which can be activated by an ultraviolet ray, and can cause a reaction of the ultraviolet curable component. Specific examples of the photopolymerization initiator which may be used include e.g., acetophenone-based photopolymerization initiators, benzoin-based photopolymerization initiators, benzyl-based photopolymerization initiators, benzoinalkyl ether-based photopolymerization initiators, benzophenone-based photopolymerization initiators, ketal-based photopolymerization initiators, thioxanthone-based photopolymerization initiators, α-ketol-based photopolymerization initiators, aromatic sulfonyl chloride-based photopolymerization initiators, photoactive oxime-based photopolymerization initiators, and the like. The photopolymerization initiator may be used alone, or two or more thereof may be used in combination.

As the photopolymerization initiator, an acetophenone-based photopolymerization initiator, or a benzoin-based photopolymerization initiator is suitable. Examples of the acetophenone-based photopolymerization initiator include e.g., 4-phenoxydichloroacetophenone, 4-t-butyl-dichloroacetophenone, diethoxyacetophenone, 1-phenyl-2-hydroxy-2-methylpropane-1-one, 1-[4-(2-hydroxyethyl)-phenyl]-2-hydroxy-2-methylpropane-1-one, 1-hydroxycyclohexyl phenyl ketone, and the like. As the benzoin-based photopolymerization initiator, for example, benzoin and the like may be exemplified.

In addition, the benzyl-based photopolymerization initiator includes, for example, benzyl and the like. Examples of the benzoinalkyl ether-based photopolymerization initiator include e.g., benzoinmethyl ether, benzoinethyl ether, benzoinpropyl ether, benzoinisopropyl ether, benzoinisobutyl ether, and the like. Examples of the benzophenone-based photopolymerization initiator include e.g., benzophenone, benzoylbenzoic acid, 3,3'-dimethyl-4-methoxybenzophenone, polyvinylbenzophenone, α-hydroxycyclohexylphenyl ketone, and the like. Examples of the ketal-based photopolymerization initiator include e.g., benzyldimethyl ketal, and the like. Examples of the thioxanthone-based photopolymerization initiator include e.g., thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone, dodecylthioxanthone, and the like.

Moreover, as the crosslinking agent, for example, a polyisocyanate-based crosslinking agent, a melamine resin, a urea resin, an aziridine-based compound, an epoxy-based crosslinking agent such as an epoxy resin, a low-molecular compound having multiple carboxyl groups, or an anhydride thereof, a polyamine, a polymer having multiple carboxyl groups, or the like may be used.

According to the adhesive sheet 1 for protecting the back face of a solar battery module, by providing to attach the adhesive sheet 1 via the adhesive compound layer 3 on the back face of a back sheet of the back face of the solar battery module in which physical defects such as damaging and cracks are caused, penetration of water vapor and the like from the physical defect sites can be prevented, and the expansion of the defect sites can be inhibited. In addition, according to the adhesive sheet for protecting the back face of a solar battery module, since the adhesive compound layer a has a given thickness, expansion of defects such as scratches and cracks can be inhibited, and penetration of water vapor and the like from outside to inside the solar battery module can be certainly prevented by embedding the adhesive compound layer into the deepest portion of the physical defect which can usually occur on the back sheet.

The adhesive sheet 11 for protecting the back face of a solar battery module shown in Fig. 2 has a substrate layer 2, an adhesive compound layer 3 laminated on one face side of the substrate layer 2, and a barrier layer 4 laminated on other face side of the substrate layer 2. Since the substrate layer 2 and the adhesive compound layer 3 are similar to those in the adhesive sheet 1 for protecting the back face of a solar battery module shown in Fig. 1, explanation of them will be omitted through designating the identical numbers.

The barrier layer 4 contains an inorganic substance. Although the inorganic substance is not particularly limited as long as it has gas barrier properties, it is preferably an inorganic oxide. The barrier layer 4 containing an inorganic oxide enables superior gas barrier properties against water vapor and the like to be exerted, and due to having an insulation property, portions having electric conductivity such as solar battery cells and wirings can be protected even in the cases in which physical defects such as cracks are significantly generated in the back sheet.

The barrier layer 4 including the inorganic oxide may be formed by vapor deposition of an inorganic oxide on one face of the substrate layer 2. The means for the vapor deposition is not particularly limited as long as vapor deposition of the inorganic oxide is executed without causing deterioration of the synthetic resin substrate layer 2 such as contraction. Examples of the applicable means include (a) physical vapor deposition (PVD) such as vacuum evaporation, sputtering, ion plating, ion cluster beam methods and the like, and (b) chemical vapor deposition (CVD) such as plasma chemical vapor deposition, thermal chemical vapor deposition, photochemical vapor deposition and the like. Among these vapor deposition, vacuum evaporation and ion plating are preferred which enable formation of the barrier layer 4 having high quality with high productivity.

The inorganic oxide that constitutes the barrier layer 4 is not particularly limited as long as it has gas barrier properties, and for example, aluminum oxide, silica oxide, titanium oxide, zirconium oxide, zinc oxide, tin oxide, magnesium oxide or the like may be used. Of these, aluminum oxide or silica oxide is particularly preferred because of favorable balance of costs and gas barrier properties.

When the barrier layer 4 is formed by vapor deposition of the inorganic oxide, the lower limit of the average thickness of the barrier layer 4 is preferably 3 Å, and particularly preferably 400 Å. In contrast, when the barrier layer 4 is formed by vapor deposition of the inorganic oxide, the upper limit of the average thickness of the barrier layer 4 is preferably 3000 Å, and particularly preferably 800 Å. When the average thickness of the barrier layer 4 is less than the aforementioned lower limit, gas barrier properties are likely to be deteriorated. To the contrary, the average thickness of the barrier layer 4 is greater than the aforementioned upper limit, less flexibility of the barrier layer 4 is achieved, whereby defects such as cracking are likely to occur.

In addition, the barrier layer 4 may include aluminum as an inorganic substance, and may be formed by vapor deposition of aluminum. When the barrier layer 4 is formed by vapor deposition of aluminum, gas barrier properties are particularly improved according to the adhesive sheet 1, and rays of light passed through the solar battery cell reflect and subjected to recycling due to the aluminum vapor deposition surface having metal gloss, whereby efficiency of electric power generation can be promoted.

As the method for forming the barrier layer 4 by vapor deposition of aluminum, a method similar to the vapor deposition method of the inorganic oxide described above may be used. When the barrier layer 4 is formed by vapor deposition of aluminum, the lower limit of the average thickness of the barrier layer 4 is preferably 10 nm, and particularly preferably 20 nm. On the other hand, the upper limit of the thickness of the barrier layer 4 formed by aluminum vapor deposition is preferably 200 nm, and particularly preferably 100 nm. When the thickness of the barrier layer 4 is less than the aforementioned lower limit, the gas barrier properties may be deteriorated. To the contrary, when the barrier layer 4 has a thickness exceeding the aforementioned upper limit, defects such as cracks are more likely to be generated in the barrier layer 4.

The barrier layer 4 may have either a monolayer structure, or a multilayer structure including two or more layers. By the formation of the barrier layer 4 having a multilayer structure, deterioration of the substrate layer 2 can be minimized through reduction of thermal burden applied during the vapor deposition, and further, adhesion properties between the substrate layer 2 and the barrier layer 4 can be improved. In addition, conditions of the vapor deposition employed in the aforementioned physical vapor deposition and chemical vapor deposition may be arbitrarily determined depending on the resin type of the substrate layer 2, thickness of the barrier layer 4, and the like.

In addition, the barrier layer 4 may be formed by a sol-gel method using a composition containing a metal alkoxide and/or a hydrolysate thereof. By forming the barrier layer 4 with such a sol-gel method, adhesiveness with the substrate layer 2 is enhanced, whereby superior gas barrier properties can be exerted. In addition, the barrier layer 4 can be formed at a comparatively low temperature by employing the sol-gel method in which the temperature is not elevated so high as in accordance with vapor deposition. Therefore, since a burden is less likely to be imposed to the substrate layer 2 which is not comparatively resistant to high temperatures, barrier layer 4 having multi layers can be easily formed.

The metal included in the metal alkoxide is exemplified by trivalent or higher valent metals such as e.g., transition metals, rare-earth metals, metals in Groups 3 to 5 in the periodic table, and metals belonging to Group 3B or Group 4 in the periodic table are preferred. The metals belonging to Group 3B in the periodic table include, for example, Al and the like. The metals belonging to Group 4 in the periodic table include, for example, Ti and Zr belonging to Group 4A, as well as Si belonging to Group 4B, and the like. Among these metals, because a film can be easily formed with a sol-gel method and a superior planarizing function of boundary surfaces is exhibited, Al and Si are preferred and Si is particularly preferred.

Examples of the alkoxy group included in the metal alkoxide include e.g., a methoxy group, an ethoxy group, a propoxy group, an isopropoxy group, a butoxy group, an isobutoxy group, a pentyloxy group, a hexyloxy group, and the like. Of these, lower alkoxy groups having 1 to 4 carbon atoms that are superior in hydrolytic polymerizability are preferred, and a methoxy group, an ethoxy group, and a propoxy group are particularly preferred. In addition, for the purpose of promoting hydrolytic polymerizability, a metal alkoxide having at least two alkoxy groups is preferred.

The metal alkoxide may have a hydrocarbon group. Examples of the hydrocarbon group include e.g., alkyl groups such as a methyl group, an ethyl group, a propyl group, an isopropyl group, a butyl group, a pentyl group, and a hexyl group; cycloalkyl groups such as a cyclopentyl group, a cyclohexyl group, and a cyclooctyl group; aryl groups such as a phenyl group, and a naphthyl group; aralkyl groups such as a benzyl group, and a 2-phenylethyl group, and the like. Among these hydrocarbon groups, alkyl groups and aryl groups are preferred. Of these alkyl groups, lower alkyl groups having 1 to 4 carbon atoms are preferred, and a methyl group, an ethyl group and a propyl group are particularly preferred. In addition, of the aryl groups, a phenyl group is preferred. The number of hydrocarbon groups in the metal alkoxide may be selected appropriately depending on the number of the alkoxy groups, and is, in general, about 0 to 2 in one molecule.

Specifically, the metal alkoxide is preferably one represented by the following formula (1):

(^{R}1 ) ₘM ( OR² ) x-m (1)

in the above formula (1): R¹ represents an alkyl group, a cycloalkyl group, an aryl group or an aralkyl group, which may have a substituent; R² represents a lower alkyl group; R¹ and R² may be different depending on "m"; M represents a trivalent or higher valent metal; X represents the valence of the metal M; m represents an integer of 0 to 2; and the difference (X - m) is no less than 2.

In particular, the metal alkoxide in which the metal is Si is preferably represented by the following formula (2):

(R¹) ₙSi (OR²) ₄₋ₙ (2)

in the above formula (2): R¹ represents an alkyl group or an aryl group, which may have a substituent; R² represents a lower alkyl group; R¹ and R² may be different depending on "n"; and n represents an integer of 0 to 2.

Specific examples of the metal alkoxide in which the metal is Al include trimethoxyaluminate, triethoxyaluminate, ethyldiethoxyaluminate, tripropoxyaluminate, and the like.

Specific examples of the metal (Si)alkoxide represented by the above formula (2) include tetramethoxysilane, methyltrimethoxysilane, ethyltrimethoxysilane, propyltrimethoxysilane, butyltrimethoxysilane, tetraethoxysilane, methyltriethoxysilane, ethyltriethoxysilane, propyltriethoxysilane, butyltriethoxysilane, tetrapropoxysilane, methyltripropoxysilane, ethyltripropoxysilane, dimethyldimethoxysilane, diethyldimethoxysilane, dipropyldimethoxysilane, dimethyldiethoxysilane, diethyldiethoxysilane, γ-chloropropyltrimethoxysilane, γ-chloropropyltriethoxysilane, γ-mercaptopropyltrimethoxysilane, γ-mercaptopropyltriethoxysilane, γ-aminopropyltrimethoxysilane, y-aminopropyltriethoxysilane, phenyltrimethoxysilane, phenyltriethoxysilane, phenyltripropoxysilane, diphenyldimethoxysilane, diphenyldiethoxysilane, and the like.

Among the metal (Si)alkoxide represented by the above formula (2), compounds having 0 to 2 alkyl group(s) or aryl group(s) having about 1 to 4 carbon atoms, and 2 to 4 alkoxy groups having about 1 to 3 carbon atoms, for example, tetramethoxysilane, methyltrimethoxysilane, ethyltrimethoxysilane, methyltriethoxysilane, tetraethoxysilane, ethyltriethoxysilane, diethyldiethoxysilane, dimethyldiethoxysilane, phenyltrimethoxysilane, phenyltriethoxysilane, and the like are particularly preferred.

In the aforementioned composition, the same type or different type of the metal alkoxide may be used alone or as a mixture of two or more thereof. Moreover, in the composition, monoalkoxysilane in which n is 3 may be added for adjusting hardness and flexibility of the composition, and the like. Furthermore, a compound of a Group 5B element such as, for example, a phosphorus-based compound such as a methyl phosphonous dimethyl ester, ethyl phosphonous dimethyl ester, trichloromethyl phosphonous diethyl ester, methyl phosphonous diethyl ester, methyl phosphonic dimethyl ester, phenyl phosphonic dimethyl ester, or phosphoric acid trialkyl ester, or a boron compound such as boric acid trialkyl ester may be added to the composition described above. Moreover, an alkaline earth metal compound having at least one hydrolyzable organic group may be added as needed to the composition described above. This alkaline earth metal compound may have both the hydrocarbon group and the hydrolyzable organic group.

In the aforementioned composition, a metal alkoxide (A) having a functional group containing at least one of nitrogen, oxygen, sulfur and halogen may be contained. By applying and curing such a composition containing the metal alkoxide (A) having a functional group containing at least one of nitrogen, oxygen, sulfur and halogen, a specific polysiloxane structure is exhibited in the barrier layer 4, and the film physical properties and in turn, gas barrier properties of the barrier layer 4 can be improved. Still more, the temperature dependency of the gas barrier properties of the barrier layer 4 can be reduced.

As the functional group containing at least one of nitrogen, oxygen, sulfur and halogen, for example, an amino group, a chlorine atom, a mercapto group, a glycidoxy group and the like may be exemplified. Examples of the metal alkoxide (A) having the functional group containing at least one of nitrogen, oxygen, sulfur and halogen include e.g., γ-chloropropyltrimethoxysilane, β-(3,4-epoxycyclohexyl)ethyltrimethoxysilane, γ-glycidoxypropyltrimethoxysilane, γ-glycidoxypropylmethyldimethoxysilane, γ-mercaptopropyltrimethoxysilane, N-β (aminoethyl)-y-aminopropyltrimethoxysilane, N-β(aminoethyl)-y-aminopropylmethyldimethoxysilane, γ-ureidepropyltriethoxysilane, bis(β-hydroxyethyl)-y-aminopropyltriethoxysilane, y-aminopropylsilicone, and the like, and either one, or at least two of these metal alkoxides may be used.

The content of the metal alkoxide (A), i.e., the content in the composition based on the entire metal alkoxide is preferably 1% by mass or greater and 50% by mass or less, and particularly preferably 3% by mass or greater and 30% by mass or less. When the content of the metal alkoxide (A) falls within the above range, a polysiloxane structure that is responsible for gas barrier properties can be provided on the barrier layer 4.

In the aforementioned composition, a solvent-soluble polymer may be contained. By forming the barrier layer 4 according to the sol-gel method using a composition containing such a polymer soluble in the solvent and the metal alkoxide, film physical properties of the barrier layer 4 are improved, and the gas barrier properties (particularly, gas barrier properties in conditions with high temperatures) of the barrier layer 4 can be further enhanced.

As the aforementioned solvent-soluble polymer, polymers having any of a variety of functional groups or functional binding groups (for example, a hydroxyl group, a carboxyl group, an ester bond, an ether bond, a carbonate bond, an amide group, an amide bond, etc.), polymers having a glycidyl group, halogen-containing polymers, and derivatives from these polymers, and the like are exemplified. These functional group or functional binding groups may be present either in the main chain or the side chain of the polymer. The solvent-soluble polymer may be either a thermoplastic resin or a thermosetting resin, which may be used either alone or as a mixture of two or more thereof. In addition, although the solvent-soluble polymer may be either inert or active for the reaction with the metal alkoxide, a nonreactive polymer is generally employed. The term "amide bond" herein referred to is not limited to "-NHC(O)-", but falls under a concept including a >NC(O)- bond unit.

Examples of the aforementioned polymer having a hydroxyl group and a derivatives thereof include e.g., polyvinyl alcohols, polyvinyl acetals, ethylene-vinyl alcohol copolymers, phenol resins, methylolmelamine and the like, and derivatives thereof (for example, acetalized products, hexamethoxymethylmelamine, etc.). Examples of the aforementioned polymer having carboxyl and derivatives thereof include e.g., homopolymers or copolymers including polymerizable unsaturated acid units such as poly(meth)acrylic acid, maleic anhydride and itaconic acid, and esterified products of these polymers. Examples of the aforementioned polymer having an ester bond include e.g., homopolymers or copolymers including units of a vinyl ester such as vinyl acetate, a (meth)acrylic ester such as methyl methacrylate (for example, polyvinyl acetate, ethylene-vinyl acetate copolymers, (meth)acrylic resins, etc.), saturated polyesters, unsaturated polyesters, vinyl ester resins, diallyl phthalate resins, cellulose esters, and the like. Examples of the polymer having an ether bond include e.g., polyalkylene oxides, polyoxyalkylene glycols, polyvinyl ethers, silicon resins, and the like. Examples of the aforementioned polymer having a carbonate bond include polycarbonates such as bisphenol A type polycarbonates.

Examples of the aforementioned polymer having an amide bond include e.g., N-acylated products such as polyoxazoline having a >N(COR)- bond, and polyalkyleneimine; polyvinylpyrrolidone having a >NC(O)- bond and derivatives thereof; polyurethane having a urethane bond -HNC(0)0-; polymers having a urea bond -HNC(0)NH-; polymers having an amide bond -C(0)NH-; polymer having a biuret linkage; polymer having an allophanate linkage; and the like. In the above formula representing the binding, R represents a hydrogen atom, an alkyl group which may have a substituent, or an aryl group which may have a substituent.

In the case of polyoxazoline having a >N(COR)- bond, the alkyl group represented by R may include, for example, an alkyl group having about 1 to 10 carbon atoms, preferably a lower alkyl group having 1 to 4 carbon atoms, and particularly, a methyl group, an ethyl group, a propyl group, an isopropyl group, or the like. The substituent of the alkyl group includes, for example, a halogen atom such as fluorine, chlorine or bromine, a hydroxyl group, an alkoxy group having about 1 to 4 carbon atoms, a carboxyl group, an alkoxycarbonyl group with an alkyl moiety having about 1 to 4 carbon atoms, and the like. Examples of the aryl group include e.g., phenyl, naphthyl groups, and the like. Examples of the substituent of the aryl group include e.g., the aforementioned halogen atoms, alkyl groups having about 1 to 4 carbon atoms, a hydroxyl group, alkoxy groups having about 1 to 4 carbon atoms, a carboxyl group, alkoxycarbonyl groups with an alkyl moiety having about 1 to 4 carbon atoms, and the like.

Examples of the oxazoline include e.g., 2-oxazoline, 2-methyl-2-oxazoline, 2-ethyl-2-oxazoline, 2-propyl-2-oxazoline, 2-isopropyl-2-oxazoline, 2-butyl-2-oxazoline, 2-dichloromethyl-2-oxazoline, 2-trichloromethyl-2-oxazoline, 2-pentafluoroethyl-2-oxazoline, 2-phenyl-2-oxazoline, 2-methoxycarbonylethyl-2-oxazoline, 2-(4-methylphenyl)-2-oxazoline, 2-(4-chlorophenyl)-2-oxazoline, and the like. In particular, 2-oxazoline, 2-methyl-2-oxazoline, 2-ethyl-2-oxazoline and the like are preferred. Polymers of such oxazoline may be used either alone, or as a mixture of two or more thereof. The polyoxazoline may be either a homopolymer or a copolymer. In addition, the polyoxazoline may be a copolymer in which polyoxazoline grafted to the polymer.

The polyoxazoline is obtained by ring-opening polymerization of oxazoline which may have a substituent in the presence of a catalyst. As the catalyst, for example, a sulfuric acid ester or a sulfonic acid ester such as dimethyl sulfate, or p-toluenesulfonate alkyl ester; a halogenated alkyl such as alkyl iodide (for example, methyl iodide); metal fluoride among Friedel-Crafts catalysts; an acid such as sulfuric acid, hydrogen iodide or p-toluenesulfonic acid, or an oxazolinium salt which is a salt formed with such an acid and oxazoline, or the like may be used.

Examples of the acylated product of polyalkyleneimine include polymers corresponding to the aforementioned polyoxazoline such as e.g., polymers having an N-acylamino group such as N-acetylamino or N-propionylamino. The polyvinylpyrrolidone and derivatives thereof include polymers of vinylpyrrolidone which may have a substituent, for example, polyvinylpyrrolidone, and the like. Examples of the polyurethane having a urethane bond include e.g., polyurethanes produced by a reaction of a polyisocyanate (tolylenediisocyanate, hexamethylenediisocyanate, etc.) with a polyol (a polyhydric alcohol such as ethylene glycol, propylene glycol, tetramethylene glycol or glycerin; a polyether polyol such as diethylene glycol, polyethylene glycol, dipropylene glycol, or polypropylene glycol; a polyester polyol, or the like). Examples of the polymer having a urea bond include e.g., polymers produced by a reaction of polyurea, polyisocyanate and polyamine (for example, a diamine such as ethylene diamine, diethylene triamine).

Examples of the polymer having an amide bond include polyamide, poly(meth)acrylamide, polyamino acid, and the like. The polymer having an amide bond is preferably a polymer of oxazoline which may have a substituent, an N-acylated product of polyalkyleneimine, polyvinylpyrrolidone, polyurethane, polyamide, poly(meth)acrylamide, and the like. Examples of the polymer having a biuret linkage include polymers produced by a reaction of the polyisocyanate with a compound having a urethane bond. Examples of the polymer having an allophanate linkage include polymers produced by a reaction of the polyisocyanate with a compound having a urea bond, and the like. Examples of the polymer having a glycidyl group include e.g., epoxy resins, homopolymers or copolymers of glycidyl (meth)acrylate, and the like. Examples of the halogen-containing polymer include e.g., polyvinyl chloride, vinyl chloride-vinyl acetate copolymers, vinylidene chloride-based polymers having a vinylidene chloride unit, chlorinated polypropylene, and the like.

The solvent-soluble polymer is, in general, soluble in water; alcohols such as methanol, ethanol, propanol, isopropanol, butanol and cyclohexanol; aliphatic hydrocarbons such as hexane and octane; alicyclic hydrocarbons such as cyclohexane; aromatic hydrocarbons such as benzene, toluene and xylene; halogenated hydrocarbons such as methyl chloride, methylene chloride, chloroform and trichloroethylene; esters such as methyl acetate, ethyl acetate and butyl acetate; ketones such as acetone and methyl ethyl ketone; ethers such as diethyl ether, dioxane, dimethoxy ethane and tetrahydrofuran; nitrogen-containing solvents (for example, N-methylpyrrolidone, nitriles such as acetonitrile, amides such as dimethyl formamide and dimethylacetamide, etc.) as well as aprotic polar solvents such as sulfoxides (for example, dimethyl sulfoxide, etc.); or mixed solvents of the same.

As the solvent-soluble polymer, those having a group capable of forming a hydrogen bond such as e.g., a hydroxyl group, a carboxyl group, an amide group, an amide bond, a nitrogen atom or the like are preferred. When such a solvent-soluble polymer having a group capable of forming a hydrogen bond is used, the solvent for the metal alkoxide and/or a hydrolysate thereof may often be one that is in common, and it is believed that the hydroxyl group of the organic metal polymer produced by hydrolytic polymerization of the metal alkoxide forms a hydrogen bond with a functional group and/or a binding group of the solvent-soluble polymer, and consequently forms a uniform organic-inorganic hybrid thereby enabling a transparent coating film which is uniform at the micro level to be formed.

In addition, as the solvent-soluble polymer, an alcohol-soluble polymer is preferred since a solvent common with that for the metal alkoxide can be used. The alcohol-soluble polymer is preferably a water-soluble polymer such as a polymer having a hydroxyl group, and particularly preferably a polymer having a nitrogen atom (for example, the polymer having an amide bond described above).

The content of the solvent-soluble polymer based on 100 parts by mass of the metal alkoxide (including a hydrolysate thereof) is preferably 40% by mass or greater and 90% by mass or less, and particularly preferably 50% by mass or greater and 80% by mass or less. When the content of the solvent-soluble polymer is below the above range, the effect of improving the gas barrier properties is deteriorated, and formation of a uniform a coating film with a complex of the inorganic polymer and the organic polymer may be difficult. On the other hand, when the content of the solvent-soluble polymer is beyond the above range, the film formability and the uniformity are likely to be improved, and the gas barrier properties may be deteriorated.

In the composition described above, an organic solvent is generally blended. As the organic solvent, an inert appropriate solvent for the polymerize reaction depending on the type of the metal alkoxide, such as for example, an alcohol, an aromatic hydrocarbon, an ether, a nitrogen-containing solvent, a sulfoxide, or a mixed solvent thereof, or the like may be used. Alternatively, the aforementioned solvent-soluble polymer may be also used as the organic solvent. This organic solvent is preferably a solvent that is miscible with the solvent for the metal alkoxide, and is particularly preferably a good solvent that is common for both the solvent-soluble polymer and the metal alkoxide.

In addition, the composition may contain a curing catalyst, and hydrolytic polymerization of the metal alkoxide may be carried out in the presence of the curing catalyst. As the curing catalyst, a tertiary amine or an acid catalyst which is substantially insoluble in water, and soluble in an organic solvent, or the like is used. Examples of the tertiary amine include e.g., N,N-dimethylbenzylamine, tripropylamine, tributylamine, tripentylamine, and the like. Examples of the acid catalyst include inorganic acids such as e.g., hydrochloric acid, sulfuric acid, nitric acid, and phosphoric acid; organic acids such as e.g., carboxylic acids such as formic acid, acetic acid, trichloroacetic acid, trifluoroacetic acid and propionic acid, sulfonic acids such as methanesulfonic acid, ethanesulfonic acid and p-toluenesulfonic acid, and the like.

In the composition for forming the barrier layer 4 by a sol-gel method may be blended as needed a variety of additives such as a plasticizer, an antioxidant, an ultraviolet ray absorbing agent, a fire retardant, an antistatic agent, a surfactant, a filler, a colorant, and the like ad libitum.

Next, a method for forming the barrier layer 4 by a sol-gel method is explained. The composition is prepared by adding a solvent-soluble polymer, a curing catalyst, an organic solvent and the like to a metal alkoxide and/or a hydrolysate thereof ad libitum, and sufficiently kneading. This composition is coated on the surface of the substrate layer 2 by a common coating method, and then dried by heating. The composition is further subjected to an aging treatment or the like to form the barrier layer 4 as a coated and cured film. This heating temperature is appropriately selected depending on the hydrolyzability of the metal alkoxide, and the heat resistance of the substrate layer 2, which temperature is preferably 50°C or higher and 120°C or lower. The polymerize reaction may be carried out in the presence of an inert gas, or under a reduced pressure. Moreover, the polymerization may be allowed while removing alcohols produced as the hydrolytic polymerization proceeds.

In the method for forming the barrier layer 4 by a sol-gel method, it is preferred to subject the composition to ultraviolet irradiation in the heating step. By thus subjecting the composition to ultraviolet irradiation in the heating step of the sol-gel method, the composition is cured at a lower temperature (no higher than 100°C), and defects of the barrier layer 4 are significantly reduced with superior film physical properties and improved adhesiveness between the barrier layer 4 and the substrate layer 2. Thus, the gas barrier properties of the barrier layer 4 can be further enhanced.

Moreover, for improving the coherent adhesiveness and the like between the substrate layer 2 and the barrier layer 4, one face of the substrate layer 2 may be subjected to a surface finishing treatment. Examples of such a surface finishing treatment for improving the adhesion properties include e.g., (a) a corona discharge treatment, an ozone treatment, low-temperature plasma treatment using an oxygen gas, a nitrogen gas or the like, a glow discharge treatment, oxidizing treatments using a chemical or the like, (b) a primer coating treatment, an undercoating treatment, an anchor coating treatment, a vapor deposition anchor coating treatment, and the like. Among these surface finishing treatments, the corona discharge treatment and the anchor coating treatment are preferred which achieve enhancement of the adhesive strength to the barrier layer 4, and are responsible for formation of compact and uniform barrier layer 4.

Examples of the anchor coating agent which may be used in the aforementioned anchor coating treatment include e.g., polyester-based anchor coating agents, polyamide-based anchor coating agents, polyurethane-based anchor coating agents, epoxy-based anchor coating agents, phenol-based anchor coating agents, (meth)acrylic anchor coating agents, polyvinyl acetate-based anchor coating agents, polyolefin-based anchor coating agents such as those including polyethylene or polypropylene as the base, cellulose-based anchor coating agents, and the like. Among these anchor coating agents, polyester-based anchor coating agents which can further enhance the adhesive strength between the substrate layer 2 and the barrier layer 4 are particularly preferred.

The lower limit of the amount of coating of the aforementioned anchor coating agent (calculated based on the solid content) is preferably 0.1 g/m², and particularly preferably 1 g/m². In contrast, the upper limit of the amount of coating of the anchor coating agent is preferably 5 g/m², and particularly preferably 3 g/m². When the amount of coating of the anchor coating agent is less than the aforementioned lower limit, the effect of improving the adhesion properties between the substrate layer 2 and the barrier layer 4 may be decreased. To the contrary, when the amount of coating of the anchor coating agent is greater than the aforementioned upper limit, strength, durability and the like of the adhesive sheet 1 for protecting the back face of a solar battery module may be deteriorated.

In the anchor coating agent described above, can be blended a variety of additives such as a silane coupling agent for improving coherent adhesiveness, an antiblocking agent for preventing blocking with the substrate layer 2, an ultraviolet ray-absorbing agent for improving weather resistance, and the like. The amount of the blending such additives is preferably 0.1% by weight or more and 10% by weight or less in light of the balance of the effect exhibited by the additive, and possible inhibition of the function to be performed by the anchor coating agent.

Furthermore, one face (the external side face not brought into contact with the substrate layer 2) of the barrier layer 4 is preferably subjected to a top coating treatment. By thus subjecting the external face of the barrier layer 4 to a top coating treatment, the barrier layer 4 is sealed and protected, and consequently, handleability of the adhesive sheet 11 is improved. In addition, even if there are defects such as scratches and recessed parts in the barrier layer 4, deterioration of the gas barrier properties can be suppressed, and further aged deterioration of the barrier layer 4 can be inhibited. As the top coating agent for use in the top coating treatment described above, one similar to the agent for use in the substrate layer 2 may be used.

The lower limit of the amount of coating of the top coating agent (calculated based on the solid content) is preferably 1 g/m², and particularly preferably 3 g/m². On the other hand, the upper limit of the amount of coating of the top coating agent is preferably 10 g/m², and particularly preferably 7 g/m². When the amount of coating of the top coating agent is less than the lower limit described above, the effect of sealing and protecting the barrier layer 4 may be inferior. On the other hand, even if the amount of coating of the top coating agent exceeds the upper limit described above, the effect of sealing and protecting the barrier layer 4 is less likely to be enhanced, and rather leads to increase in the thickness of the adhesive sheet 11, whereby results contrary to demands for reduction in thickness and weight saving may be produced.

It is to be noted that various types of additives such as a silane coupling agent for improving contact adhesion properties, an ultraviolet ray absorbing agent for improving weather resistance etc., an inorganic filler for improving heat resistance etc., may be mixed ad libitum in the top coating agent. The amount of mixing such additives is preferably 0.1% by mass or greater and 10% by mass or less in light of the balance between development of effects of the additive, and inhibition of functions of the top coating agent.

Since the adhesive sheet 11 for protecting the back face of a solar battery module thus has the barrier layer 4 laminated on other face side of the substrate layer 2, superior gas barrier properties are provided, and the mechanical strength can be improved. Moreover, in the case in which the adhesive sheet 11 for protecting the back face of a solar battery module has the barrier layer 4 including an inorganic oxide, and due to having a superior insulation property, portions having electric conductivity such as solar battery cells and wirings can be protected even in the cases in which deep physical defects are generated in the back sheet.

The adhesive sheet 21 for protecting the back face of a solar battery module shown in Fig. 3 has a substrate layer 2, an adhesive compound layer 3 laminated on one face side of the substrate layer 2, a barrier layer 5 laminated on other face side of the substrate layer 2, and an adhesive compound layer 6 laminated between the substrate layer 2 and the barrier layer 5. Since the substrate layer 2 and the adhesive compound layer 3 are similar to those in the adhesive sheet 1 for protecting the back face of a solar battery module shown in Fig. 1, explanation of them will be omitted through designating the identical numbers.

An aluminum foil is used for the barrier layer 5. The material entity of the aluminum foil may include aluminum or an aluminum alloy, and is preferably an aluminum-iron-based alloy (soft material). The iron content in the aluminum-iron-based alloy is preferably no less than 0.3% and no greater than 9.0%, and particularly preferably no less than 0.7% and no greater than 2.0%.When the iron content is less than the lower limit described above, an effect of preventing generation of pinhole may be insufficient. To the contrary, when the iron content exceeds the upper limit described above, the flexibility is inhibited, and the processibility may be deteriorated. Furthermore, as the material of the aluminum foil, soft aluminum subjected to an annealing treatment is preferred in light of prevention of the pinhole generation.

The lower limit of the thickness (average thickness) of the aluminum foil is preferably 6 µm, and particularly preferably 15 µm. On the other hand, the upper limit of the thickness of the aluminum foil is preferably 30 µm, and particularly preferably 20 µm. When the thickness of the aluminum foil is less than the lower limit described above, breaking of the aluminum foil is likely to occur during the processing, and the gas barrier properties may be deteriorated resulting from the pinhole and the like. On the other hand, when the thickness of the aluminum foil is greater than the upper limit described above, cracks and the like may be generated during the processing, and the thickness and the weight of the adhesive sheet 21 for protecting the back face'of a solar battery module increase, whereby results contrary to social demands for thin and light modeling may be produced.

In light of prevention of dissolution and corrosion, the surface of the aluminum foil may be subjected to a surface treatment such as, for example, a chromate treatment, a phosphate treatment, or a lubricating resin-coating treatment. Moreover, in light of acceleration of the adhesion properties, the surface of the aluminum foil may be subjected to a coupling treatment and the like. Additionally, the aluminum foil may have an increased surface area by forming fine irregularities by means of emboss processing etc., in order to allow a high heat dissipation function to be exerted from the surface.

In addition, one face (the face on the side not brought into contact with the adhesive compound layer 6) of the aluminum foil that is provided as the barrier layer 5 is preferably subjected to a top coating treatment similarly to the barrier layer 4 of the adhesive sheet 11 for protecting the back face of a solar battery module. By thus subjecting the external face of the barrier layer 5 to a top coating treatment, the barrier layer 5 is sealed and protected, and consequently, handleability of the adhesive sheet 21 is improved. In addition, even if there are defects such as scratches and recessed parts in the barrier layer 5, deterioration of the gas barrier properties can be suppressed, and further aged deterioration of the barrier layer 5 can be inhibited.

Although the adhesive that constitutes the adhesive compound layer 6 is not particularly limited, an adhesive for lamination or a melt-extruded resin is suitably used. Examples of the adhesive for lamination include e.g., adhesives for dry lamination, adhesives for wet lamination, adhesives for hot melt lamination, adhesives for nonsolvent lamination, and the like. Among these adhesives for lamination, adhesives for dry lamination are particularly preferred which are excellent in the adhesive strength, durability, weather resistance and the like, and have the sealing and protecting functions to compensate for defects (for example, scratch, pinhole, recessed part and the like) of the surface of the substrate layer 2.

Examples of the adhesive for dry lamination include e.g., polyvinyl acetate-based adhesives, polyacrylic ester-based adhesives consisting of a homopolymer of an ethyl, butyl, 2-ethylhexyl ester or the like of acrylic acid, or a copolymer of the homopolymer and methyl methacrylate, acrylonitrile, styrene or the like, cyano acrylate-based adhesives, ethylene copolymer-based adhesives consisting of a copolymer of ethylene and a monomer such as vinyl acetate, ethyl acrylate, acrylic acid, methacrylic acid or the like, cellulose-based adhesives, polyester-based adhesives, polyamide-based adhesives, polyimide-based adhesives, amino resin-based adhesives consisting of an urea resin, a melamine resin or the like, phenol resin-based adhesives, epoxy-based adhesives, polyurethane-based adhesives, reactive (meth)acrylic adhesives, rubber-based adhesives consisting of a chloroprene rubber, a nitrile rubber, a styrene-butadiene rubber or the like, silicone-based adhesives, inorganic adhesives consisting of alkali metal silicate, low-melting point glass or the like. Among these adhesives for dry lamination, polyurethane-based adhesives, particularly polyester urethane-based adhesives are preferred which prevent the adhesive sheet 21 for protecting the back face of a solar battery module from decrease in the adhesive strength and from delamination caused by the long-term use out of doors, and which suppress deterioration such as yellowing and the like of the adhesive compound layer 6. Meanwhile, aliphatic polyisocyanate accompanied by less thermal yellowing is preferred as a curing agent.

As the melt extruded resin one or two or more thermoplastic resin(s) such as, for example, polyethylene-based resins, polypropylene-based resins, acid modified polyethylene-based resins, acid modified polypropylene-based resins, ethylene-acrylic acid or methacrylic acid copolymers, SURLYN-based resins, ethylene-vinyl acetate copolymers, polyvinyl acetate-based resins, ethylene-acrylic ester or methacrylic ester copolymers, polystyrene-based resins, polyvinyl chloride-based resins and the like can be used. When the extrusion lamination method is employed in which the melt extruded resin is used, it is desired that the opposing face to the lamination of each film described above is subjected to the aforementioned surface finishing treatment such as anchor coating treatment or the like for achieving more rigid adhesion strength.

The lower limit of the amount of lamination (calculated based on the solid content) of the adhesive compound layer 6 is preferably 1 g/m², and particularly preferably 3 g/m². In contrast, the upper limit of the amount of lamination of the adhesive compound layer 6 is preferably 10 g/m², and particularly preferably 7 g/m². When the amount of lamination of the adhesive compound layer 6 is smaller than the aforementioned lower limit, adhesion strength and the sealing function to compensate for the defects of the barrier layer 4 may not be attained. To the contrary, when the amount of lamination of the adhesive compound layer 6 is greater than the aforementioned upper limit, strength and durability of the laminated layer may be deteriorated.

In the adhesive for lamination or the melt extruded resin for forming the adhesive compound layer 6 may be blended a variety of additives ad libitum such as e.g., a solvent, a lubricant, a crosslinking agent, an antioxidant, an ultraviolet ray-absorbing agent, a light stabilizer, a filler, a reinforcing fiber, a strengthening agent, an antistatic agent, a fire retardant, a flame retardant, a foaming agent, an fungicide, a pigment and the like for the purpose of improving and modifying the handleability, heat resistance, weather resistance, mechanical properties and the like.

Since an aluminum foil is used for the barrier layer 5 in the adhesive sheet 21 for protecting the back face of a solar battery module, gas barrier properties against water vapor and the like and mechanical strength are further improved. Additionally, due to high thermal conductivity of aluminum, superior heat dissipation effect is achieved, and thus elevation of the temperature of the solar battery cells can be inhibited, whereby prolongation of the duration of use of the solar battery module can be further promoted.

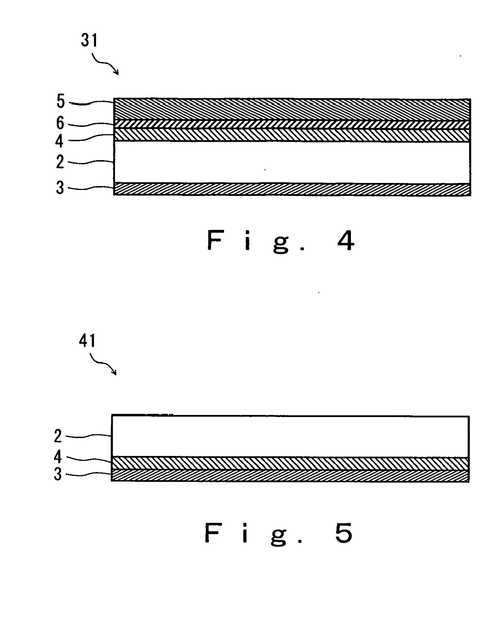

The adhesive sheet for protecting the back face of a solar battery module 31 shown in Fig. 4 has a substrate layer 2, an adhesive compound layer 3 laminated on one face side of the substrate layer 2, a first barrier layer 4 containing an inorganic substance and laminated on the other face side of the substrate layer 2, an adhesive compound layer 6 laminated on one face (the face on the side not brought into contact with the substrate layer 2) of the first barrier layer 4, and a second barrier layer 5 consisting of an aluminum foil laminated on one face (the face on the side not brought into contact with the first barrier layer 4) of the adhesive compound layer 6. The substrate layer 2 and the adhesive compound layer 3 are similar to those in the adhesive sheet 1 for protecting the back face of a solar battery module shown in Fig. 1; the first barrier layer 4 containing an inorganic substance is similar to the adhesive sheet for protecting the back face of a solar battery module shown in Fig. 2; and the second barrier layer 5 consisting of an aluminum foil, and the adhesive compound layer 6 are similar to the adhesive sheet for protecting the back face of a solar battery module shown in Fig. 3; therefore, explanation of them will be omitted through designating the identical numbers.

Since the adhesive sheet for protecting the back face of a solar battery module 31 has thus two barrier layers 4 and 5 via the adhesive compound layer 6, extremely superior water vapor-barrier function and mechanical strength are provided. In addition, even if the adhesive compound layer 6 has defects such as pinholes, crystalline interfaces, and cracks being present on the surface of the inside barrier layer 4, the adhesive sheet 31 achieves significantly improved gas barrier properties against water vapor and the like due to coverage of such surface defects.

The adhesive sheet for protecting the back face of a solar battery module 41 shown in Fig. 5 has a substrate layer 2, an adhesive compound layer 3 laminated on one face side of the substrate layer 2, and a barrier layer 4 laminated between the substrate layer 2 and the adhesive compound layer 3. The substrate layer 2 and the adhesive compound layer 3 are similar to those in the adhesive sheet 1 for protecting the back face of a solar battery module shown in Fig. 1, and the first barrier layer 4 containing an inorganic substance is similar to the adhesive sheet for protecting the back face of a solar battery module shown in Fig. 2; therefore, explanation of them will be omitted through designating the identical numbers.

According to the adhesive sheet for protecting the back face of a solar battery module 41, due to having a barrier layer 4 similarly to the adhesive sheet 11 for protecting the back face of a solar battery module shown in Fig. 2, superior gas barrier properties are achieved, and the mechanical strength can be improved. Moreover, since the barrier layer 4 is laminated between the substrate layer 2 and the adhesive compound layer 3 in the adhesive sheet for protecting the back face of a solar battery module 41, protection is enabled without subjecting the barrier layer 4 to a top coating treatment and the like. Therefore, the production is facilitated, and physical durability is improved as generation of defects and the like of the barrier layer 4 can be inhibited.

In these adhesive sheets 1, 11, 21, 31 and 41 for protecting the back face of a solar battery module, one face (the face on the side not brought into contact with the substrate layer 2, and in the adhesive sheet 41, the face on the side not brought into contact with the barrier layer 4) of the adhesive compound layer 3 is preferably covered with a release sheet. Since the adhesive sheet for protecting the back face of a solar battery module is covered with the release sheet on one face, the adhesive compound layer can be prevented from contact with other substance by immediately before the operation of attachment, and thus the workability is improved, and the adhesion function of the adhesive sheet in attaching can be enhanced.

Although the release sheet is not particularly limited, an appropriate film material constituted with a film of a synthetic resin such as polyethylene, polypropylene, an ethylene-vinyl acetate copolymer, an ethylene-vinyl alcohol copolymer or polyethylene terephthalate, a rubber sheet, paper, a cloth, a nonwoven fabric, a net, an expanded sheet, a metal foil or a laminate thereof, or the like may be used. The surface of the release sheet is preferably subjected to a releasability-imparting treatment such as a silicone treatment, a long-chain alkyl treatment or a fluorine treatment as needed in order to improve release characteristics from the adhesive compound layer 3. The release characteristics of the release sheet can be controlled by regulating the type and/or the amount of coating etc., of the reagent used for the releasability-imparting treatment.

The solar battery module 51 shown in Fig. 6 has a translucent substrate 52, a filler layer 53, a plurality of solar battery cells 54, a filler layer 55, as well as a back sheet 56, and the adhesive sheet 1 for protecting the back face of the solar battery module laminated in this order from the front face side. A part of the back face of the back sheet 56 is provided with a junction box 58 having two terminals of a wiring 57 that connects each solar battery cell 54.

The translucent substrate 52 is to be laminated on the frontmost face, and requires: a) to have transmittivity of sunlight, and electrical insulation properties b) to be excellent in mechanical, chemical and physical strength, specifically, in weather resistance, heat resistance, durability, water resistance, gas barrier properties against water vapor and the like, wind blast resistance, chemical resistance, and toughness; and c) to have high surface hardness, and to be excellent in antifouling properties to prevent the surface from fouling, accumulation of dirt and the like.

As the material for forming the translucent substrate 52, glass or a synthetic resin may be used. Examples of the synthetic resin used in the translucent substrate 52 include e.g., polyethylene-based resins, polypropylene-based resins, cyclic polyolefin-based resins, fluorine-based resins, polystyrene-based resins, acrylonitrile-styrene copolymers (AS resins, acrylonitrile-butadiene-styrene copolymers (ABS resins), polyvinyl chloride-based resins, fluorine-based resins, poly(meth)acrylic resins, polycarbonate-based resins, polyester-based resins such as polyethylene terephthalate and polyethylene naphthalate, polyamide-based resins such as a variety of nylon, polyimide-based resins, polyamideimide-based resins, polyaryl phthalate-based resins, silicone-based resins, polyphenylenesulfide-based resins, polysulfone-based resins, acetal-based resins, polyether sulfone-based resins, polyurethane-based resins, cellulose-based resins, and the like. Among these resins, fluorine-based resins, cyclic polyolefin-based resins, polycarbonate-based resins, poly(meth)acrylic resins or polyester-based resins are particularly preferred.

In the case of the translucent substrate 52 made of a synthetic resin, (a) lamination of a transparent vapor deposition film of an inorganic oxide such as silicon oxide, aluminum oxide or the like on one face thereof by the PVD or CVD method as described above for the purpose of improving the gas barrier properties and the like; and (b) blending a variety of additives such as e.g., a lubricant, a crosslinking agent, an antioxidant, an ultraviolet ray-absorbing agent, an antistatic agent, a light stabilizer, a filler, a reinforcing fiber, a strengthening agent, a fire retardant, a flame retardant, a foaming agent, an fungicide, a pigment and the like for the purpose of improving and modifying the processibility, heat resistance, weather resistance, mechanical properties, dimension accuracy and the like are also acceptable.

The thickness (average thickness) of the translucent substrate 52 is not particularly limited, and may be determined ad libitum such that necessary strength, gas barrier properties and the like are provided depending on the material used. The thickness of the translucent substrate 52 made of the synthetic resin is preferably 6 µm or greater and 300 µm or less, and particularly preferably 9 µm or greater and 150 µm or less. Moreover, the thickness of the translucent substrate 32 made of glass is generally about 3 mm.

The filler layer 53 and the filler layer 55 are filled around the solar battery cell 54 between the translucent substrate 52 and the back sheet 56, and has (a) adhesiveness between the translucent substrate 52 and the back sheet 56; and scratch resistance, shock absorbing properties and the like for protecting the solar battery cell 54. The filler layer 53 laminated on the surface of the solar battery cell 54 has transparency that permits transmission of the sunlight, in addition to the various functions as described above.

Examples of the material for forming the filler layer 53 and the filler layer 55 include e.g., fluorine-based resins, ethylene-vinyl acetate copolymer, ionomer resins, ethylene-acrylic acid or methacrylic acid copolymers, acid-modified polyolefin-based resins prepared by modification of a polyolefin-based resin such as a polyethylene resin, a polypropylene resin or polyethylene with an unsaturated carboxylic acid such as acrylic acid, polyvinylbutyral resins, silicone-based resins, epoxy-based resins, (meth)acrylic resins and the like. Among these synthetic resins, fluorine-based resins, silicone-based resins or ethylene-vinyl acetate-based resins that are excellent in the weather resistance, heat resistance, gas barrier properties and the like are preferred.

Moreover, the material which can be used for forming the filler layer 53 and the filler layer 55 includes heat reversible crosslinkable olefin-based polymer compositions described in Japanese Unexamined Patent Application Publication No. 2000-34376. More specifically the composition includes (a) a modified olefin-based polymer prepared by modification with unsaturated carboxylic anhydride and unsaturated carboxylate ester, with the average biding number of the carboxylic anhydride group per molecule being one or more, and with the ratio of the number of the carboxylate ester group to the number of the carboxylic anhydride group in the modified olefin-based polymer being 0.5 to 20, and (b) a hydroxyl group-containing polymer having an average binding number of the hydroxyl group per molecule being one or more, in which the ratio of the number of the hydroxyl group in the component (b) to the number of the carboxylic anhydride group in the component (a) is 0.1 to 5, and the like.

In the material for forming the filler layer 53 and the filler layer 55 may be blended a variety of additives ad libitum such as e.g., a crosslinking agent, a thermal antioxidant, a light stabilizer, an ultraviolet ray-absorbing agent, a photooxidation inhibitor and the like for the purpose of improving weather resistance, heat resistance, gas barrier properties and the like. Moreover, the thickness of the filler layer 53 and the filler layer 55 is not particularly limited, but is preferably 200 µm or greater and 1000 µm or less, and particularly preferably 350 µm or greater and 600 µm or less.

The aforementioned solar battery cell 54 is a photovoltaic device that converts light energy into electrical energy, and is provided between the filler layer 53 and the filler layer 55. A plurality of the solar battery cells 54 are laid on a substantially identical plane, which are wired in series or in parallel. As the solar battery cell 54, for example, crystalline silicon solar cell elements such as single crystalline silicon type solar battery elements, polycrystalline silicon type solar battery elements and the like, amorphous silicon solar battery elements of single joint type, tandem structure type and the like, semiconductor solar cell elements with compounds of groups 3 to 5 such as gallium arsenic (GaAs), indium phosphorus (InP) and the like, compound semiconductor solar cell elements with compounds of groups 2 to 6 such as cadmium tellurium (CdTe), copper indium selenide (CuInSe₂) and the like can be used, and the hybrid element of the same can be also used. The filler layer 53 or the filler layer 55 is also filled between a plurality of the solar battery cells 54 without any gap.

The back sheet 56 protects the solar battery cell 54, and the filler layers 53 and 55 from the back face, and has gas barrier properties against water vapor, oxygen gas etc., in addition to basic performances such as strength, weather resistance and heat resistance. A well-known sheet may be used as the back sheet 56. The back sheet 56 has a multilayer structure in which a pair of synthetic resin layers are laminated on the front face and back face of the gas barrier layer.

The adhesive sheet 1 for protecting the back face of a solar battery module is provided to attach on the back face of the back sheet 56 via the adhesive compound layer 3. The adhesive sheet 1 for protecting the back face of a solar battery module is cut into a shape in which a portion corresponding to the junction box 58 is excluded.

The method for production of the solar battery module 51 is not particularly limited, but in general, includes (1) a step of superposing the translucent substrate 52, the filler layer 53, a plurality of the solar battery cells 54, the filler layer 55 and the back sheet 56 in this order, (2) a step of laminating to perfect integral molding by a vacuum heat lamination method or the like in which they are integrated by vacuum aspiration and heat pressure joining, (3) a step of providing the junction box 58 on the back face of the back sheet 56, and (4) a step of laminating the adhesive sheet 1 for protecting the back face of a solar battery module on the back face of the back sheet 56 at a site except for the portion on which the junction box 58 was provided. In the method for production of the solar battery module 51, (a) coating of a heat melt adhesive, a solvent type adhesive, a photocurable adhesive or the like, (b) to the opposing face to the lamination an ozone treatment, a corona discharge treatment, a low-temperature plasma treatment, a glow discharge treatment, an oxidizing treatment, an under coating treatment, a primer coating treatment, an anchor coating treatment or the like can be carried out for the purpose of achieving the adhesiveness between each layer.

It should be noted that the adhesive sheet 1 for protecting the back face of a solar battery module may be laminated on the back face of a solar battery module already put into practical use, which includes a translucent substrate 52, a filler layer 53, multiple solar battery cells 54, a filler layer 55, and a back sheet 56 laminated in this order, and which is provided with junction box 58 having two terminals of a wiring 57 that connects each solar battery cell 54 on the back face of the back sheet 56, or may be laminated in production of the solar battery module.

Since the solar battery module 51 has the adhesive sheet 1 for protecting the back face of a solar battery module as described above, even in the case in which physical defects such as scratches and cracks 59 had been already generated on the surface of the back sheet 56 resulting from use for a long period of time and the like, the physical defects 59 are filled with the adhesive compound layer 3 of the adhesive sheet 1 for protecting the back face of a solar battery module, whereby expansion of the physical defects 59 is suppressed, and permeabilization of water vapor and the like from the physical defect 59 sites can be prevented, Accordingly, extension of useful life of the solar battery module can be promoted. Also, in the case of a solar battery module in which no physical defect such as a crack is generated on the back face of the back sheet 56, extension of useful life of the adhesive sheet 1 solar battery module is enabled since the solar battery module 51 can be maintained in the state not having a physical defect on the back face by replacing the adhesive sheet 1 periodically or when a physical defect is generated.

It should be noted that the adhesive sheet for protecting the back face of a solar battery module of the present invention and a solar battery module using the same are not limited to the foregoing embodiments. For example, the solar battery module may have any of the adhesive sheets 11, 21, 31, 41 for protecting the back face of a solar battery module and other adhesive sheet for protecting the back face of a solar battery module laminated, other than the adhesive sheet 1 for protecting the back face of a solar battery module.

Alternatively, the barrier layer formed by vapor deposition may be also laminated to provide multiple layers via other layer. According to such an adhesive sheet for protecting the back face of a solar battery module, the barrier layer provided in plural number can result in not only just improvement of the water vapor barrier property, but also increase of compactness of the barrier layer of the external side as a consequence of coverage of the physical surface defects in the surface of the inner barrier layer between layers of the barrier layer, and enhancement of the smoothness of the interface on which the barrier layer of the external side is laminated. Therefore, defects such as pinholes, crystalline interfaces and cracks in the barrier layer of the second or subsequent layers are reduced according to the adhesive sheet, and thus gas barrier properties against water vapor and the like are improved. The layer provided between the barrier layers laminated by vapor deposition may be a layer formed by the sol-gel method described above.

Additionally, a fine irregular shape may be provided on, for example, one outermost surface of the adhesive sheet 1 for protecting the back face of a solar battery module (outermost surface on the side of the face not having the laminated adhesive compound layer with respect to the substrate layer) by emboss processing or the like. By thus subjecting such a face to fine irregular-forming processing, the surface area increases, leading to improvement of heat dissipation properties. Accordingly, elevation of temperature of the solar battery module can be suppressed; therefore, enhancement of efficiency of electric power generation, and extension of useful life of the solar battery module can be achieved.

Moreover, the barrier layer may be provided on two face sides with respect to the substrate layer. The barrier layer may be laminated by vapor deposition of aluminum, an inorganic oxide of a metal or the like, or an aluminum foil may be laminated as the barrier layer. By thus laminating the barrier layer on two face sides with respect to the substrate layer, gas barrier properties, physical durability and the like of the adhesive sheet for protecting the back face of a solar battery module can be further improved.

### INDUSTRIAL APPLICABILITY

As in the foregoing, the adhesive sheet for protecting the back face of a solar battery module of the present invention is used as an adhesive sheet that protects the back face of a solar battery module for the purpose of extension of useful life of the solar battery module. In particular, the present adhesive sheet can be suitably used as an adhesive sheet for protecting a solar battery module installed outdoors which can be used in situations accompanied by severe aged deterioration.

### [Explanation of the Reference Symbols]

1, 11, 21, 31, 41 adhesive sheet for protecting the back face of a solar battery module
2 substrate layer
3 adhesive compound layer
4 barrier layer
5 barrier layer
6 adhesive compound layer
51 solar battery module
52 translucent substrate
53 filler layer
54 solar battery cell
55 filler layer
56 back sheet for solar battery module
57 terminal
58 junction box
59 physical defect

## Claims

1. An adhesive sheet for protecting the back face of a solar battery module, the adhesive sheet comprising:
a synthetic resin substrate layer; and an adhesive compound layer laminated on one face side of the substrate layer, wherein
said adhesive compound layer has an average thickness of 0.01 mm or greater and 1 mm or less.

2. The adhesive sheet for protecting the back face of a solar battery module according to claim 1, wherein an acrylic adhesive compound is used as an adhesive compound that constitutes the adhesive compound layer.

3. The adhesive sheet for protecting the back face of a solar battery module according to claim 1, wherein a butyl rubber-based adhesive compound is used as an adhesive compound that constitutes the adhesive compound layer.

4. The adhesive sheet for protecting the back face of a solar battery module according to claim 1, wherein an ultraviolet curable adhesive compound is used as an adhesive compound that constitutes the adhesive compound layer.

5. The adhesive sheet for protecting the back face of a solar battery module according to claim 1 further comprising a barrier layer laminated at least one of: on another face side of the substrate layer; and between the substrate layer and the adhesive compound layer,
wherein the barrier layer contains an inorganic substance.

6. The adhesive sheet for protecting the back face of a solar battery module according to claim 5, wherein the inorganic substance is an inorganic oxide.

7. The adhesive sheet for protecting the back face of a solar battery module according to claim 5, wherein the inorganic substance is aluminum.

8. The adhesive sheet for protecting the back face of a solar battery module according to claim 5 further comprising another barrier layer laminated on one of face side of the barrier layer of claim 5.

9. The adhesive sheet for protecting the back face of a solar battery module according to claim 1, wherein one face of the adhesive compound layer is covered with a release sheet.

10. A solar battery module comprising a transparent substrate, a first filler layer, solar battery cells as a photovoltaic device, a second filler layer, a back sheet, and an adhesive sheet for protecting the back face of the solar battery module laminated in this order from the front face side,
the adhesive sheet for protecting the back face of a solar battery module according to claim 1 is provided to attach via the adhesive compound layer thereof on the back face of the back sheet.
